# EUROPEAN PATENT APPLICATION

(11) **EP 2 782 136 A2**
(43) Date of publication of application: **24.09.2014**
(21) Application number: 14158524.0
(22) Date of filing: 10.03.2014
(51) Int. Cl.: H01L 27/146

(54) **Solid state imaging device and portable information terminal**

(30) Priority: 22.03.2013 JP 2013060647
(71) Applicant: Kabushiki Kaisha Toshiba, Tokyo 105-8001 (JP)
(72) Inventor: Suzuki, Kazuhiro, Tokyo, 105-8001 (JP); Ueno, Risako, Tokyo, 105-8001 (JP); Kobayashi, Mitsuyoshi, Tokyo, 105-8001 (JP); Kwon, Honam, Tokyo, 105-8001 (JP); Funaki, Hideyuki, Tokyo, 105-8001 (JP)
(74) Representative: HOFFMANN EITLE

(57) **Abstract**

A solid state imaging device according to an embodiment includes: an imaging element including a plurality of pixels; a bonding layer formed to be in contact with the imaging element; a first microlens array formed to be in contact with the bonding layer, and including a plurality of first microlenses with a refractive index higher than a refractive index of the bonding layer; and a main lens located above the first microlens array.

## Description

### FIELD

Embodiments described herein relate generally to solid state imaging devices and portable information terminals.

### BACKGROUND

Various techniques such as a technique using reference light and a stereo ranging technique using two or more cameras are known as imaging techniques for obtaining a depth-direction distance to a subject, serving as two-dimensional array information. In particular, in recent years, imaging devices capable of obtaining distance information at relatively low costs have been increasingly needed to serve as newly developed consumer input devices.

In a conventional imaging device using light field photographic technology capable of switching between a general high-resolution imaging mode, in which the light field photographic technology is not used, and an imaging mode based on the light field photographic technology, no microlens array is required in the high-resolution imaging mode, and it is necessary that a microlens array is arranged on an optical axis in the imaging mode based on the light field photographic technology.

It could be understood that a light field camera can be obtained by extending the function of a diaphragm mechanism in an ordinary camera. In an optical sense, a light field camera is formed of a multiple lens camera. With a light field camera, it is possible to photograph a plurality of images simultaneously, each image with a different angle of view and a different focal point. By analyzing the image data of such images, it is possible to generate an image that is in focus over the entire area. Furthermore, with a light field camera, it is possible to measure a distance using the depth of field, or estimate the direction of light source by the image data analysis. Thus, it is possible to obtain information that cannot be obtained with a conventional camera.

In view of this, a compound-eye imaging device that has an imaging lens and is capable of obtaining a large number of parallax images with a plurality of lenses has been suggested. Such an imaging device includes an imaging lens, a microlens array onto which light passing through the imaging lens is incident, and an imaging element for receiving the light outputted from the microlens array.

A mechanism for connecting a semiconductor substrate including pixel photodiodes and a microlens array with connection posts having a predetermined height is known, the connection posts defining a fine imaging distance of the microlens array and fixing the microlens array to the semiconductor substrate including the pixel photodiodes.

In such a solid state imaging device including an imaging lens, a microlens array to which light from the imaging lens is incident, and an imaging element for receiving the light from the microlens array to form a compound-eye optical system for obtaining a reconstructed image, a highly accurate alignment of the microlens array and the imaging element is needed in consideration of the focal length of the microlens array.

However, it has been difficult for a conventional solid state imaging device, which supports the microlens array by a supporting mechanism, to align the microlens array and the imaging element in consideration of the focal length of the microlens array. As a result, there is a problem in that the manufacturing yield of such a device is low and the manufacturing costs thereof are increased.

### BRIEF DESCRIPTION OF THE DRAWINGS

Fig. 1 is a cross-sectional view showing a solid state imaging device according to the first embodiment.
Fig. 2 is a schematic diagram showing an enlarged view of an imaging element, a microlens array, and a main lens of the solid state imaging device according to the first embodiment.
Figs. 3(a) to 3(d) are cross-sectional views showing a method of manufacturing the solid state imaging device according to the first embodiment.
Figs. 4(a) to 4(c) are cross-sectional views showing the method of manufacturing the solid state imaging device according to the first embodiment.
Figs. 5(a) to 5(e) are schematic diagrams for explaining a method of manufacturing the solid state imaging device according to the first embodiment from a wafer.
Fig. 6 is a cross-sectional view showing a solid state imaging device according to a modification of the first embodiment.
Fig. 7 is a cross-sectional view showing a solid state imaging device according to the second embodiment.
Fig. 8 is a schematic diagram showing an enlarged view of an imaging element, a microlens array, and a main lens of the solid state imaging device according to the second embodiment.
Fig. 9 is a cross-sectional view showing a solid state imaging device according to a modification of the second embodiment.
Fig. 10 is a diagram showing a portable information terminal according to the third embodiment.

### DETAILED DESCRIPTION

A solid state imaging device according to an embodiment includes: an imaging element including a plurality of pixels; a bonding layer formed to be in contact with the imaging element; a first microlens array formed to be in contact with the bonding layer, and including a plurality of first microlenses with a refractive index higher than a refractive index of the bonding layer; and a main lens located above the first microlens array.

Embodiments will now be explained with reference to the accompanying diagrams.

### (First Embodiment)

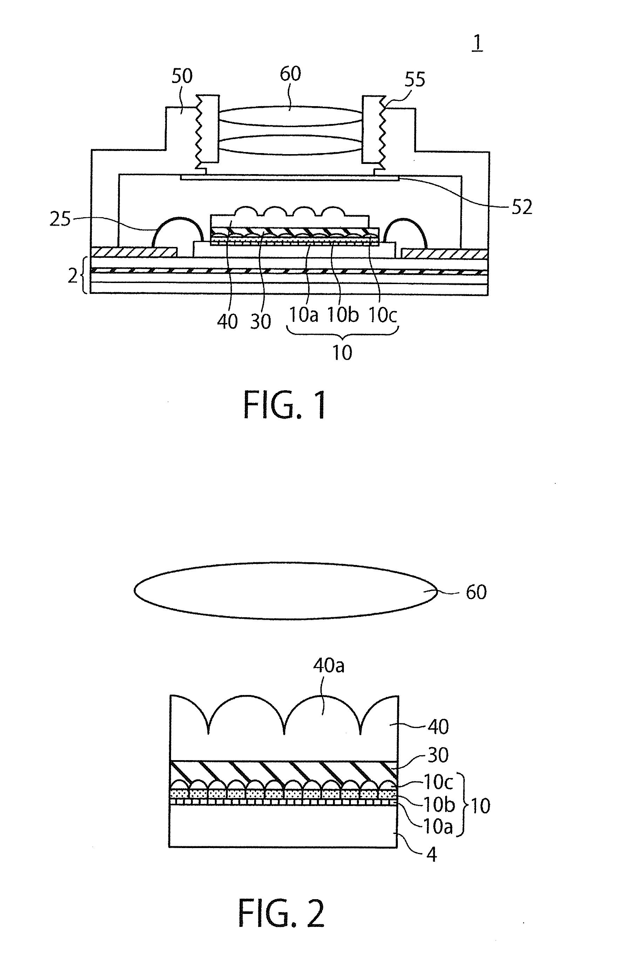

Fig. 1 shows a cross-sectional view of a solid state imaging device according to the first embodiment. The solid state imaging device 1 of the first embodiment includes an imaging element 10, a planarizing layer (bonding layer) 30, a microlens array 40, and a main lens 60. The imaging element 10 includes a plurality of pixels 10a of, for example, photodiodes, formed on a semiconductor substrate 4 on a mounting board 2. The pixels 10a are arranged in an array form, for example, on a first surface of the semiconductor substrate 4.

A driving circuit and a readout circuit not shown in Fig. 1 are formed on the semiconductor substrate 4. The driving circuit drives the pixels 10a, and the readout circuit reads an electric signal that is a signal charge converted from an optical signal by each of the pixels 10a. The read electric signal is sent to the outside by a bonding wire 25 connecting the semiconductor substrate and the mounting board 2.

The imaging element 10 may further include color filters 10b located above the pixels 10a, and a pixel microlens array (second microlens array) 10c including pixel microlenses (second microlenses) located above the color filters 10b. The color filters 10b, if included, are located between the semiconductor substrate and the planarizing layer 30, for example, to face the planarizing layer 30. The pixel microlens array 10c, if included, is located between the semiconductor substrate and the planarizing layer 30, for example, to face the planarizing layer 30. If both the color filters 10b and the pixel microlens array 10c are included, the pixel microlens array 10c is located between the color filters 10b and the planarizing layer 30, for example, to face the planarizing layer 30. The color filters 10b are located to correspond to the pixels 10a. The imaging element 10 may include multiple types of color filters 10b. Each microlens of the pixel microlens array 10c corresponds to one of the pixels 10a. The imaging element 10 may include a plurality of pixel microlens arrays 10c.

The planarizing layer 30 is formed on the imaging element 10 to be in contact with the imaging element 10. The planarizing layer 30 is in contact with, for example, the semiconductor substrate of the imaging element 10. If the imaging element 10 includes the color filter 10b, the planarizing layer 30 is in contact with the color filter 10b. If the imaging element 10 includes the pixel microlens array 10c, the planarizing layer 30 is in contact with the pixel microlens array 10c.

The microlens array 40 including a plurality of microlenses (first microlenses) is formed on the planarizing layer 30. The microlens array (first microlens array) 40 is in contact with the planarizing layer 30. The plurality of microlenses corresponds to a plurality of pixel blocks each including a plurality of pixels. Thus, each microlens corresponds to a plurality of pixels. Each microlens projects toward a side opposite to the side where the imaging element 10 is located, i.e., toward a side to which light rays come from a subject.

The microlens array 40 has a flat surface on the side where the planarizing layer 30 is located. The microlens array 40 is formed of microlenses which are, for example, convex-plano lenses projecting toward the main lens 60.

A visible light transmitting substrate (infrared cut filter (IRCF)) 52 may be formed above the microlens array 40. The IRCF 52 may be formed of a material that cuts off unnecessary infrared rays, or may include a film for cutting off infrared rays. The IRCF 52 is supported by a camera body 50, for example. The main lens 60 is located above the microlens array 40. The main lens 60 is an optical imaging system including at least one lens, for forming an image from light rays from a subject. The main lens 60 is connected to the camera body 50 by a bonding layer 55. A light shielding cover (not shown) is attached to the periphery portion of the mounting board 2 to shield unnecessary light rays.

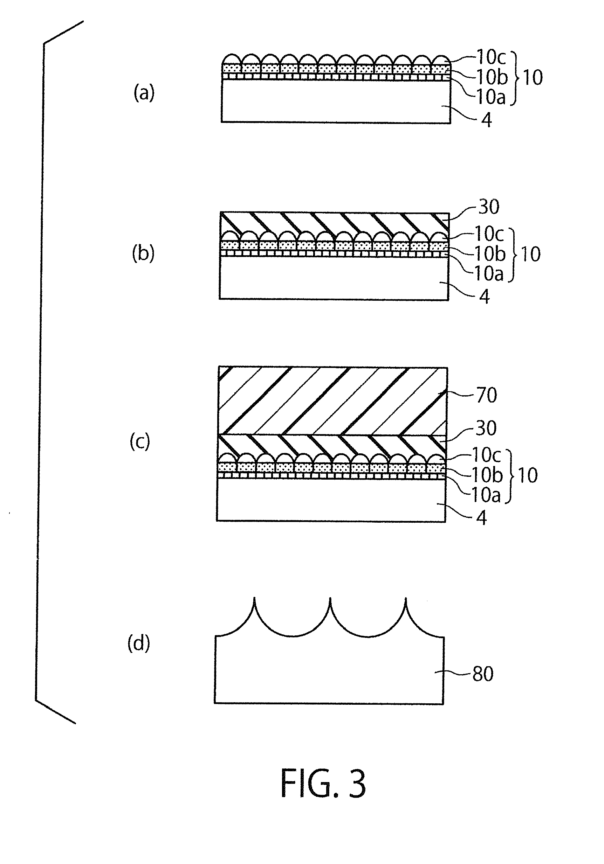

Fig. 2 is a schematic diagram showing an enlarged view of the imaging element 10, the microlens array 40 including a plurality of microlenses 40a, and the main lens 60 of the solid state imaging device according to the first embodiment. Figs. 3(a) to 4(c) are cross-sectional views showing a method of manufacturing the imaging element 10 and the microlens array 40.

Photodiodes to serve as the pixels 10a of the imaging element 10 are formed on the semiconductor substrate 4. The color filters 10b including red (R), green (G), blue (B), and transparent (W) color filters are located above the pixels. The color filters 10b are arranged in, for example, a Bayer array. The pixel microlens array 10c is formed immediately above the color filters 10b (Fig. 3(a)). Each microlens in the pixel microlens array 10c corresponds to one of the pixels 10a, and can be formed to be in a lens shape by, for example, photoresist reflowing. The refractive index of the microlens array 40 and the pixel microlens array 10c is preferably 1.4 or more.

The planarizing layer 30 is formed immediately above the pixel microlens array 10c (Fig. 3(b)). The planarizing layer 30 can be formed to have a desired thickness by spin coating an organic film. The refractive index of the planarizing layer 30 is preferably 1.3 or less.

Next, a material layer 70 for forming the microlens array 40 is formed on the planarizing layer 30. The material layer 70 for forming the microlens array 40 is formed of a material that is transparent to light in a visible wavelength band, and an ultraviolet-curing resin or thermosetting resin can be used as the material. The material layer 70 can be formed by such means as spin coating, dispensing coating, and squeegee printing (Fig. 3(c)).

Thereafter, a microlens array template 80 for forming the microlens array 40 is prepared (Fig. 3(d)). The microlens array template 80 has projections and recesses in the directions opposite to those of the final microlens array. In this embodiment, the microlens array template 80 has a concave lens pattern on its surface to form the microlens array 40 having convex microlenses. The microlens array template 80 can be formed from, for example, a quartz substrate. A predetermined pattern is formed on the quartz substrate by isotropic etching, thereby obtaining the microlens array template 80 with a concave lens pattern.

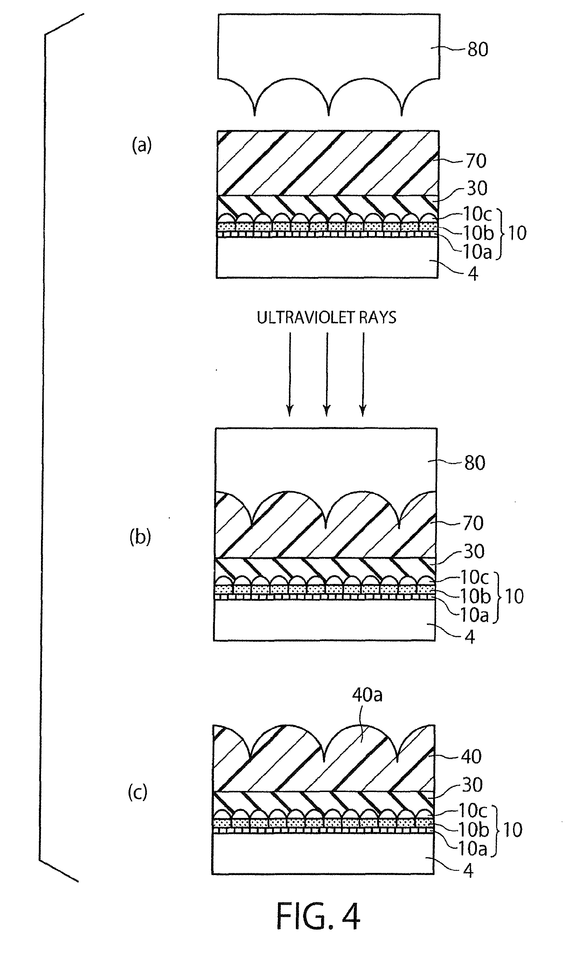

The surface of the microlens array template 80 having the convex pattern is pressed to the material layer 70 for forming the microlens array 40 (Fig. 4(a), 4(b)). If a quartz substrate is used to form the microlens array template 80 as described above, ultraviolet rays emitted from above pass through the microlens array template 80 and reach the ultraviolet-curing resin for forming the microlens array 40. If necessary, a pressure is applied to the microlens array template 80, the substrate can be heated, and ultraviolet radiation for temporary curing can be performed at this stage. In the process of curing the microlens array 40, ultraviolet radiation is performed. If necessary, a pressure is applied to the microlens array template 80, and the substrate can be heated also at this stage. Although an ultraviolet curing resin is used to form the material layer 70 for forming the microlens array 40 in the above example, a thermosetting resin can also be used.

Through the above manufacturing process, a microlens array 40 including convex-plano microlenses is formed immediately above the planarizing layer 30 (Fig. 4(c)). The microlens array 40 has a flat interface with the planarizing layer 30, and includes projections projecting toward the main lens.

As described above, the solid state imaging device according to the first embodiment has a structure in which the planarizing layer 30 is formed on the top surface of the imaging element 16, and the microlens array 40 is formed on the planarizing layer 30. Accordingly, the focal length of the microlens array 40 is determined by the thickness etc. of the planarizing layer 30 supporting the microlens array 40. As a result, the imaging element 10 and the microlens array 40 can be optically arranged with high controllability in terms of distance. The focal length of the microlens array 40 is in a range of 1 µm to 100 mm, and the total thickness of the planarizing layer 30 is preferably within the range of the focal length of the microlens array 40.

According to the solid state imaging device of the first embodiment, the employment of imprinting method enables the bonding of the microlens array onto the imaging element in a wafer level, thereby considerably reducing the manufacturing costs.

Furthermore, as convex-plano lenses are used to form the microlens array, the spherical aberration can be reduced. If plano-convex lenses are used, light is not refracted at the front portion, but refracted only at the rear portion. Accordingly, the refraction angle becomes large. In contrast, if a convex-plano lens is used, light is refracted at both the front portion and the rear portion with the refraction angle at each refraction being small since a convex-plano hemispherical lens has a smaller spherical aberration. Normally, the focal length of a microlens array is defined to be in a range of a few tens microns to a hundred and a few tens microns. Accordingly, an optical arrangement without a multilayer structure has a difficulty in thinning a support of the microlens array, for example a glass substrate, in the order defined in the first embodiment. Therefore, the plano-convex structure should be employed.

However, the structure of the first embodiment enables the stacking of a microlens layer immediately above the imaging element. Therefore, the convex-plano lens structure can be employed. As described above, the microlens array can be formed by an imprinting method using a resin material. The refractive index of the microlens array is defined to be, for example, 1.4 or more. The microlens array and the pixel microlens array are generally formed of a resin material suitable for forming a lens shape with a refractive index of 1.4 or more. Since the microlens array and the pixel microlens array have similar refractive indexes, if the low refractive index planarizing layer described above is not arranged therebetween, there is a possibility that the light passing through the microlens array cannot suitably pass through the pixel microlens array that is expected to serve as an optical element, which may lead to a decrease in efficiency to focus light on the pixels. If the low refractive index planarizing layer is located between the microlens array and the pixel microlens array, a difference in refractive index is caused between the microlens array and the pixel microlens array, which causes the pixel microlens array to function suitably.

By employing such a structure, a solid state imaging device with a high yield and reduced implementation costs can be achieved. In addition, the employment of the convex-plano lens structure can reduce the spherical aberration.

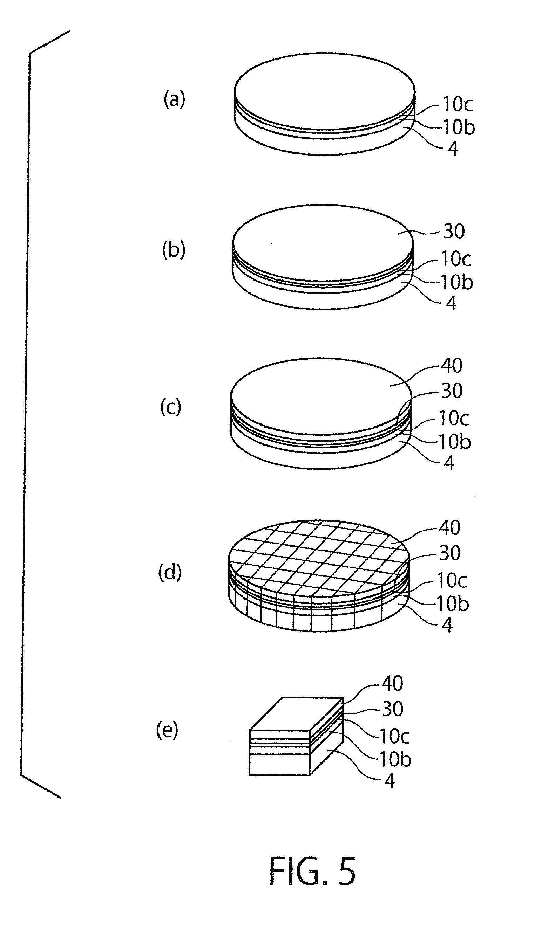

Figs. 5(a) to 5(e) are diagrams for explaining a method of manufacturing the solid state imaging device according to the first embodiment in a wafer level.

A semiconductor substrate 4 is prepared, on which a plurality of pixels, a driving circuit for driving the pixels, and a readout circuit for reading signals from the pixels are formed, and color filters 10b are formed on the semiconductor substrate 4. Then, a pixel microlens array 10c is formed on the color filters 10b (Fig. 5(a)). Subsequently, a planarizing layer 30 is formed on the pixel microlens array 10c (Fig. 5(b)). Thereafter, a microlens array 40 is formed on the planarizing layer 30 by an imprinting method to form a solid state imaging device in a wafer level (Fig. 5(c)). Then, blade dicing or laser dicing is performed to cut the wafer into chips, thereby obtaining a solid state imaging device in a chip size (Fig. 5(d), 5(e)).

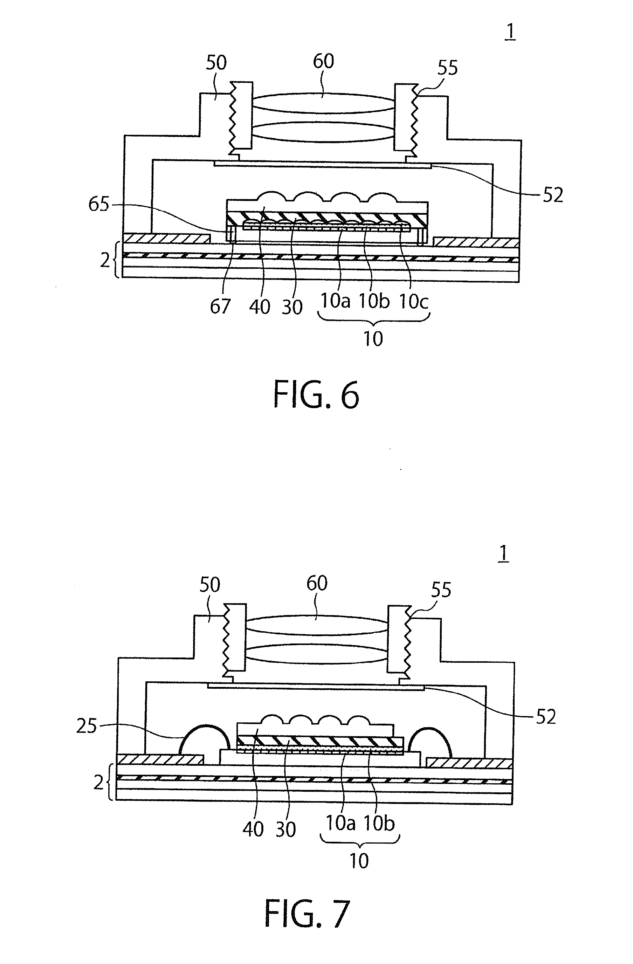

If the microlens array is directly formed on the pixels in a wafer level as in the solid state imaging device according to a modification of the first embodiment shown in Fig. 6, an external interface for driving the pixels and reading signals is formed by a through-electrode 65, and signals can be extracted from a surface opposite to the light-incident surface. The mounting board 2 can be electrically connected to an electrical connection unit 67 provided to the semiconductor substrate, without using the bonding wire 25.

As described above, according to the first embodiment, a solid state imaging device can be provided, which is easy to be positioned in consideration of the focal length of the microlens array, and has a high manufacturing yield. Furthermore, the tilt and dislocation of the microlens array, when it is assembled, can be solved, the implementation yield can be improved, and the assembling costs can be reduced. Furthermore, since the microlenses of the microlens array are formed of convex-plano lenses, the spherical aberration can be reduced, which leads to improving the image quality.

### (Second Embodiment)

Fig. 7 shows a solid state imaging device according to the second embodiment. The solid state imaging device according to the second embodiment does not include the pixel microlens array 10c of the solid state imaging device according to the first embodiment shown in Fig. 1.

If the semiconductor substrate 4, on which a plurality of pixels are formed, serves as an imaging element of back side illumination type, no interlayer insulating film (not shown) is present on the light-incident surface. Such interlayer insulating films include wiring lines for reading operation, and are formed in an imaging element of front side illumination type. An imaging element of front side illumination type often needs pixel microlenses to focus light rays from the interlayer insulating film located above on a pixel portion (specifically, a diode portion) formed on the semiconductor substrate 4. However, an imaging element of back side illumination type does not need such a structure. Furthermore, regardless of whether an imaging element is of front side illumination type or back side illumination type, the pixel size is being decreased in recent years. The pixel pitch of less than 1 um makes it difficult to achieve a highly efficient focusing of light even if fine pixel microlenses corresponding to the fine pixel pitch are used, because of the diffraction limit of light rays in visible waveform band. For this reason, the second embodiment does not include pixel microlenses.

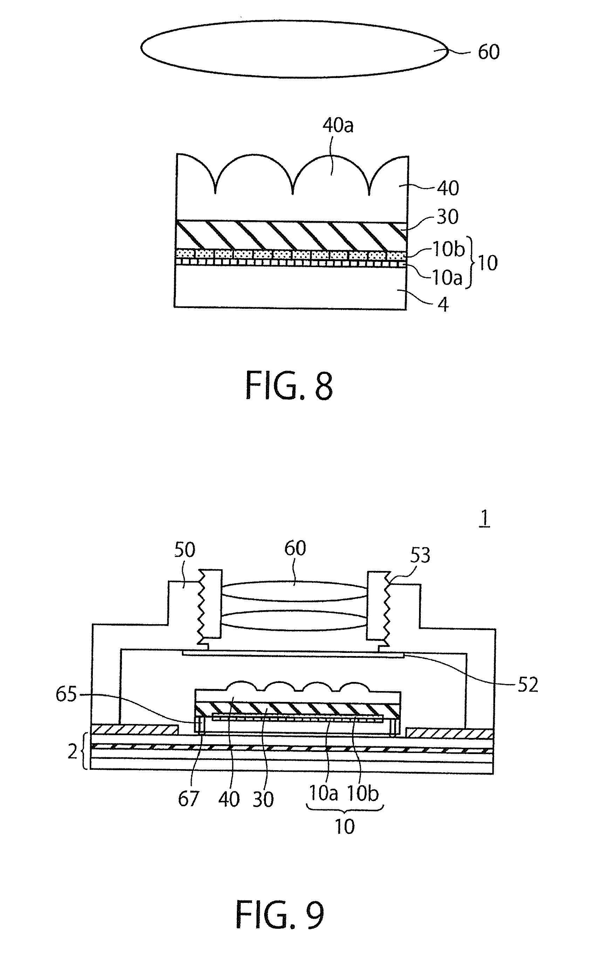

As shown in Fig. 8, the imaging element 10 includes the pixels 10a and the color filters 10b. Fig. 8 is a schematic enlarged view of the imaging element 10, the microlens array 40 having the microlenses 40a, and the main lens 60.

The solid state imaging device according to the second embodiment can be manufactured by the same process as the solid state imaging device according to the first embodiment shown in Figs. 3(a) to 4(c), except that the pixel microlens array 10c is not formed on the semiconductor substrate 4.

If the microlens array is directly formed above the pixels in a wafer level as in the case of the solid state imaging device according to the modification of the second embodiment shown in Fig. 9, an external interface for driving the pixels and reading signals is formed by a through-electrode 65 and signals can be extracted from the surface opposite the light-incident surface. The mounting board 2 can be electrically connected to an electrical connection unit 67 provided to the semiconductor substrate, without using the bonding wire 25.

As described above, according to the second embodiment, a solid state imaging device can be provided, which is easy to be positioned in consideration of the focal length of the microlens array, and has a high manufacturing yield. Furthermore, the tilt and dislocation of the microlens array, when it is assembled, can be solved, the implementation yield can be improved, and the assembling costs can be reduced. Furthermore, since the microlenses of the microlens array are formed of convex-plano lenses, the spherical aberration can be reduced, which leads to improving the image quality.

### (Third Embodiment)

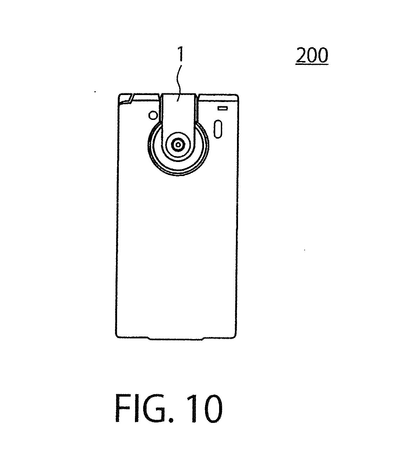

Fig. 10 shows a portable information terminal according to the third embodiment. The portable information terminal 200 according to the third embodiment includes, as a camera module, the solid state imaging device 1 of the first or second embodiment. ' The portable information terminal shown in Fig. 10 is just an example.

According to the third embodiment, a portable information terminal can be provided, which includes a solid state imaging device that is easy to be positioned in consideration of the focal length of the microlens array, and has a high manufacturing yield. Furthermore, since the microlenses of the microlens array are formed of convex-plano lenses, the spherical aberration can be reduced, which leads to improving the image quality.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A solid state imaging device comprising:
an imaging element including a plurality of pixels;
a bonding layer formed to be in contact with the imaging element;
a first microlens array formed to be in contact with the bonding layer, and including a plurality of first microlenses with a refractive index higher than a refractive index of the bonding layer; and
a main lens located above the first microlens array.

2. The device according to claim 1, wherein each of the first microlenses in the first microlens array is a convex-plano lens having a flat surface on a side facing the bonding layer and a convex surface facing the main lens.

3. The device according to claim 1 or 2, wherein a refractive index of each of the first microlenses of the first microlens array is 1.4 or more.

4. The device according to claim 1, 2 or 3, wherein the refractive index of the bonding layer is 1.3 or less.

5. The device according to any one of the preceding claims, wherein each of the first microlenses in the first microlens array corresponds to two or more of the pixels.

6. The device according to any one of the preceding claims, wherein the imaging element further including a second microlens array that faces the bonding layer and has second microlenses each corresponding to one of the pixels.

7. The device according to any one of the preceding claims, wherein the imaging element includes color filters that face the bonding layer.

8. The device according to any one of the preceding claims, wherein the imaging element, the bonding layer, and the first microlens array are closely bonded.

9. The device according to any one of the preceding claims, wherein the imaging element includes a semiconductor substrate mounted on a mounting board, and the semiconductor substrate and the mounting board are electrically connected with each other by a bonding wire.

10. The device according to any one of the preceding claims 1 to 8, wherein the imaging element includes a semiconductor substrate mounted on a mounting board, and the semiconductor substrate and the mounting board are electrically connected with each other by a through-electrode.

11. The device according to any one of the preceding claims, wherein the first microlens array is formed by imprinting.

12. A portable information terminal comprising the device according to any one of the preceding claims.
